(19) **Europäisches Patentamt**
**European Patent Office**
**Office européen des brevets**

(11) **EP 4 534 622 A1**

(12) **EUROPEAN PATENT APPLICATION**

(43) Date of publication:
**09.04.2025 Bulletin 2025/15**

(21) Application number: **24202946.0**

(22) Date of filing: **26.09.2024**

(51) International Patent Classification (IPC):
**C09G 1/02** (2006.01)   **C09K 3/14** (2006.01)

(52) Cooperative Patent Classification (CPC):
**C09G 1/02; C09K 3/1463**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.10.2023  KR 20230131542**

(71) Applicant: **SK enpulse Co., Ltd.
Pyeongtaek-si, Gyeonggi-do 17784 (KR)**

(72) Inventor: **HAN, DEOK SU
03142 Seoul (KR)**

(74) Representative: **BCKIP Part mbB
MK1
Landsbergerstraße 98, 3.Stock
80339 München (DE)**

(54) **POLISHING COMPOSITION FOR SEMICONDUCTOR PROCESS AND POLISHING METHOD OF SUBSTRATE USING THE SAME**

(57)   A polishing composition for a semiconductor process includes abrasive particles and a surfactant. A volume of foam measured immediately after stirring 3L of the polishing composition at 25°C at a speed of 1,000 rpm for 30 minutes and letting it stand for 10 minutes is 50 mL or less. When applied to a Chemical Mechanical Planarization (CMP) process, this composition improves polishing process convenience and provides a polished surface with a reduced frequency of defects.

**EP 4 534 622 A1**

**Description**

This application claims the priority benefit of Korean Patent Application No. 10-2023-0131542, filed on October 4, 2023.

BACKGROUND

1. Field

The present disclosure relates to polishing compositions for semiconductor processing and methods for polishing substrates using the same.

2. Background Art

As semiconductor devices become finer and more highly integrated, finer patterning techniques are being used, resulting in more complex surface structures and larger steps between layers. In semiconductor device manufacturing, chemical mechanical polishing (CMP) is used as a planarization technique to remove steps in certain layers formed on a substrate.

In the CMP process, a surface of the substrate is polished by applying a slurry to a polishing pad while applying pressure to the substrate and rotating it. Different process steps require different objects to be leveled and different properties of the applied slurry.

Polishing metal wiring after it has been formed requires sufficient polishing speed and uniformity while minimizing dishing or erosion.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a polishing composition for a semiconductor process includes abrasive particles; and a surfactant.

A volume of foam measured immediately after stirring 3L of the polishing composition at 25°C at a speed of 1,000 rpm for 30 minutes and standing for 10 minutes may be 50 mL or less.

The polishing composition for the semiconductor process may have a viscosity of 0.7 cP to 1.5 cP at 25°C.

The polishing composition for the semiconductor process may have a dynamic surface tension of 25 mN/m to 70 mN/m at a bubble lifetime of 10 seconds.

The surfactant may include a nonionic surfactant.

The nonionic surfactant may include a first nonionic surfactant having a Hydrophilic-Lipophilic Balance (HLB) value of 10 or greater.

The nonionic surfactant may include a second nonionic surfactant having a Hydrophilic-Lipophilic Balance (HLB) value of 8 or less.

The surfactant may include a polymeric surfactant.

A weight average molecular weight of the polymeric surfactant may range from 150 g/mol to 3,000 g/mol.

The polishing composition for a semiconductor process may further include an antifoaming agent.

The antifoaming agent may include a water-soluble polymer.

A weight average molecular weight of the antifoaming agent may range from 200 g/mol to 2,000 g/mol.

The antifoaming agent may include a polyglycerin-based compound.

The polishing composition for a semiconductor process may have a pH of 2 to 5.

The abrasive particle may have a positively charged surface.

In another general aspect, a method of manufacturing a substrate includes polishing a substrate by applying a polishing composition for a semiconductor process as a slurry. The polishing composition may include abrasive particles and a surfactant. A volume of form measured immediately after stirring 3L of the polishing composition at 25°C at a speed of 1,000 rpm for 30 minutes and standing for 10 minutes is 50 mL or less.

Other features and aspects will be apparent from the following detailed description, the drawings, and the claims.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment, e.g., as to what an example or embodiment may include or implement, means that at least one example or embodiment exists where such a feature is included or implemented, while all examples are not limited thereto.

As used herein, the terms "about," "substantially," and the like are meant to be used at or near the numerical value when manufacturing and material tolerances inherent in the recited meanings are presented, and to prevent unscrupulous infringers from taking unfair advantage of the disclosure where precise or absolute numerical values are recited to aid in the understanding of the embodiments.

Throughout this specification, the term "combination thereof" as used in a Markush-style representation means one or more mixtures or combinations selected from the group of components described in the Markush-style representation and includes one or more selected from the group of components.

Throughout the present specification, references to "A and/or B" shall mean "A, B, or, A and B".

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

Throughout this specification, terms such as "first", "second" or "A", "B" are used to distinguish one from the other unless otherwise indicated.

As used herein, the reference to B being located on A means that B is located on A with or without other layers located therebetween, and is not to be construed as limiting B to being located directly abutting the surface of A.

In this specification, singular expressions, unless otherwise indicated, is construed to include the singular or plural as construed from the context.

Below, the present disclosure is described in detail.

Properties of **Polishing** Compositions

A polishing composition for a semiconductor process, according to the present disclosure, includes abrasive particles and a surfactant.

A volume of foam measured immediately after stirring 3L of the polishing composition at 25°C at a speed of 1,000 rpm for 30 minutes and standing for 10 minutes is 50 mL or less.

Polishing compositions for semiconductor processes may include surfactants to control the affinity of the polishing composition for a surface to be polished and to inhibit the adsorption of abrasive particles and organic particles on the surface to be polished. However, a polishing composition comprising the surfactant may form a plurality of bubbles during the supplying process or during the polishing process. A large number of bubbles may excessively increase the volume of the polishing composition, which may cause problems during the supplying process of the polishing composition and may cause agglomeration between abrasive particles during the polishing process, which may cause scratches to form on a polished surface.

The present disclosure may effectively improve chemical mechanical polishing (CMP)-related process convenience by controlling bubble-related properties of the polishing composition comprising the surfactant, and may effectively suppress the occurrence of defects on the polishing target surface due to agglomeration and adsorption of abrasive particles, etc.

The method for measuring the volume of bubbles is as follows.

The method first adds 3 L of a polishing composition for semiconductor processing to a glass reactor having a volume of 5 L. The polishing composition is then stirred at a speed of 1,000 rpm for 30 minutes at 25°C using a 4 blades rotor with a total length of 10 cm. The rotor is adapted from those commonly used in the field of stirrers. After 10 minutes from the end of stirring, the height of the bubbles formed in the glass reactor is measured. From the height value and the inner diameter of the reactor, the volume of the bubbles is calculated.

The volume of bubbles measured by stirring 3 L of a polishing composition for a semiconductor process at a speed of 1,000 rpm at 25°C for 30 minutes and leaving for 10 minutes may be 50 mL or less. The volume of the bubbles may be 40 mL or less. The volume of the bubbles may be 30 mL or less. The volume of the bubble may be greater than or equal to 1 mL. In such cases, the polishing composition can be easily dispensed into the polishing object and can contribute to inhibiting the agglomeration of abrasive particles during the polishing process.

The polishing composition for the semiconductor process may have a viscosity of 0.7 cP to 1.5 cP at 25 °C.

The viscosity of the polishing composition may be adjusted within a predetermined range in the present disclosure, which may effectively reduce the amount of bubbles generated in the polishing composition comprising the surfactant and help the generated bubbles dissipate quickly. Furthermore, by adjusting the viscosity within a predetermined range in the present disclosure, it may contribute to the polishing composition having a stable polishing rate on the polishing target surface over a relatively long period of time.

The viscosity of the polishing composition for semiconductor processing is measured with a viscometer.

The polishing composition for semiconductor processing may have a viscosity of 0.7 cP to 1.5 cP at 25 °C. The viscosity may be 0.8 cP or more. The viscosity may be 0.9 cP or more. The viscosity may be 1.3 cP or less. The viscosity may be 1.1 cP or less. This prevents excessive foaming during the polishing process while helping the polishing composition maintain a stable polishing speed on the polishing target surface.

The dynamic surface tension at a bubble lifetime of 10 seconds for a polishing composition for semiconductor processing may be from 25 mN/m to 70 mN/m.

The polishing compositions of the present disclosure may present relatively controlled dynamic surface tension within a relatively short bubble lifetime. Such polishing compositions may present good affinity for the substrate surface to be polished and organic particles present on the substrate, even when frequent migration occurs due to relative motion between the substrate to be polished and the polishing pad. At the same time, it can help suppress excessive bubble generation in the polishing composition during the polishing process.

The dynamic surface tension of the polishing composition is measured by the maximum bubble pressure method using a bubble pressure tensiometer. The maximum bubble pressure method involves inserting the polishing composition to be measured into a capillary, measuring the internal pressure of the bubbles that form at the end of the capillary when gas is injected into the capillary, and calculating the dynamic surface tension from this measurement. In the maximum bubble pressure method, bubble lifetime is the time from when bubbles begin to form at the end of the capillary until the internal pressure of the bubbles reaches its maximum.

In dynamic surface tension measurements, the time interval is 1 second and the sample volume is 2 mL. As an example, a bubble pressure tensiometer may be the BPA-1P model manufactured from Sinterface Tech.

The dynamic surface tension at a bubble lifetime of 10 seconds of the polishing composition for a semiconductor process may be from 25 mN/m to 70 mN/m. The dynamic surface tension may be 69 mN/m or less. The dynamic surface tension may be 68 mN/m or less. The dynamic surface tension may be greater than or equal to 30 mN/m. The dynamic surface tension may be greater than or equal to 32 mN/m. The dynamic surface tension may be greater than or equal to 34 mN/m. When a polishing composition having the above characteristics is applied to a CMP process, it can provide a polished surface with improved uniformity and can reliably control the amount of bubbles that may occur during the polishing process.

The polishing composition for a semiconductor process may have a pH of 2 to 5. The pH may be greater than or equal to 2.5. The pH may be greater than or equal to 3.0. The pH may be 4.8 or less. The pH may be 4.6 or less. The pH may be 4.4 or less. The pH may be 4.2 or less. In such cases, the polishing composition may present good abrasive properties on the polishing target surface, including the silicon oxide film, and may help to stably disperse the abrasive particles.

The pH of polishing compositions for semiconductor processes is measured with a pH meter.

The zeta potential of the polishing composition for a semiconductor process may be from +10 mV to +50 mV. The zeta potential may be greater than or equal to +15 mV. The zeta potential may be greater than or equal to +20 mV. The zeta potential may be less than or equal to +45 mV.

The zeta potential of the abrasive particles may be between +10 mV and +50 mV. The zeta potential may be greater than or equal to +15 mV. The zeta potential may be greater than or equal to +20 mV. The zeta potential may be less than or equal to +45 mV.

The zeta potential of the polishing composition for a semiconductor process and the abrasive particles is measured under conditions where the pH of the polishing composition for a semiconductor process is between 2.0 and 5.0.

In such cases, the polishing composition may exhibit good abrasive properties on silicon oxide films that exhibit a surface negative charge while exhibiting a stable dispersion.

**Components of the Polishing Composition**

Abrasive particles

The polishing composition may include abrasive particles.

The abrasive particles may include metal oxide particles and/or silicon oxide particles. The abrasive particles may include silica. The abrasive particles may include colloidal silica.

The abrasive particles may include 70 wt% or more of colloidal silica. The abrasive particles may include 80 wt% or more of colloidal silica. The abrasive particles may include 90 wt% or more of colloidal silica. The abrasive particles may be colloidal silica.

The abrasive particles may have a positively charged surface. The abrasive particles may be particles having a surface modified to have a positively charged surface. The abrasive particles may be particles having a surface modified with a compound having an amine group. The abrasive particles may be particles having a surface modified with an amino silane.

The abrasive particles may have a positively charged surface under conditions where the pH of the polishing composition for a semiconductor process is between 2.0 and 5.0.

The amino silanes may be exemplarily any one selected from a group consisting of 3-aminopropyltriethoxysilane, bis[(3-triethoxysilyl)propyl]amine, 3-aminopropyltrimethoxysilane, bis[(3- trimethoxysilyl)propyl]amine, 3-aminopropylmethyldiethoxysilane, 3-aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, N-[3-(trimethoxysilyl)propyl]butylamine, and of combinations thereof.

The polishing composition for a semiconductor process can include from 50 ppm (by weight) to 300 ppm (by weight) of amino silane. The polishing composition for a semiconductor process may include 70 ppm (by weight) or more of amino silane. The polishing composition for a semiconductor process may include 100 ppm (by weight) or more of amino silane. The polishing composition for a semiconductor process may include 120 ppm (by weight) or more of amino silane. The polishing composition for a semiconductor process may include 250 ppm (by weight) or less of amino silane. The polishing composition for a semiconductor process may include 220 ppm (by weight) or less of amino silane. The polishing composition for a semiconductor process may include 200 ppm (by weight) or less of amino silane. The polishing composition for a semiconductor process may include 180 ppm (by weight) or less of amino silane. In such cases, the polishing composition may have a better polishing rate on the silicon oxide film, provide a smoother polishing of the substrate surface to be polished, and exhibit improved dispersibility. At the same time, it can effectively inhibit the adsorption of the residue of the surface modifier to the polished surface.

The polishing composition for a semiconductor process may include from 1 wt% to 10 wt% of an abrasive particle. The polishing composition for a semiconductor process may include 2 wt% or more of an abrasive particle. The polishing composition for a semiconductor process may include less than or equal to 8 wt% of an abrasive particle. The polishing composition for a semiconductor process may include 5 wt% or less of an abrasive particle. In such a case, the polishing composition may have an excellent polishing rate on the surface to be polished while reliably inhibiting agglomeration of the abrasive particle.

The abrasive particle may have an average diameter of 20 nm or more. The average diameter may be 30 nm or more. The average diameter may be 40 nm or more. The average diameter may be 70 nm or less. The average diameter may be 60 nm or less. The average diameter may be 50 nm or less. In such cases, the polishing composition may exhibit a good polishing rate on the surface to be polished while stably controlling the frequency of defects on the polished surface.

The average diameter means the average diameter of a primary particle of the abrasive particle.

Surfactant

The polishing composition for a semiconductor process includes a surfactant. The surfactant can improve the affinity of the polishing composition to the silicon oxide film, allowing the polishing composition to be evenly distributed over the surface to be polished during the polishing process.

The surfactant may be a nonionic surfactant. The nonionic surfactant can adhere to the surface of the polishing target surface with sufficient strength to effectively prevent abrasive particles having positively charged surface from adsorbing on the surface to be polished, while still being readily removed from the polished surface.

The nonionic surfactant may include a first nonionic surfactant having a Hydrophilic-Lipophilic Balance (HLB) value of 10 or greater.

The HLB value for nonionic surfactants can be calculated using Equation 1 below.

[Equation 1]

$$HLB = 20 \times \frac{Mh}{M}$$

In Equation 1 above, Mh is a molecular weight of the hydrophilic portion of the nonionic surfactant and M is the molecular weight of the nonionic surfactant.

The first nonionic surfactant has a relatively high hydrophilicity and can effectively remove organic particles present on the surface of the substrate to be polished.

The polishing composition for a semiconductor process may include 1 part by weight or more of the first nonionic surfactant based on 100 parts by weight of the total nonionic surfactant. The polishing composition for a semiconductor process may include 3 parts by weight or more of the first nonionic surfactant based on 100 parts by weight of the total nonionic surfactant. The polishing composition for a semiconductor process may include 5 parts by weight or more of the first nonionic surfactant based on 100 parts by weight of the total nonionic surfactant. The polishing composition for a semiconductor process may include 25 parts by weight or less of the first nonionic surfactant based on 100 parts by weight of the total nonionic surfactant. The polishing composition for a semiconductor process may include 20 parts by weight or less of the first nonionic surfactant based on 100 parts by weight of the total nonionic surfactant. The polishing composition for a semiconductor process may include 15 parts by weight or less of the first nonionic surfactant based on 100 parts by weight of the total nonionic surfactant.

In this case, the adsorption of abrasives and organic matter on the surface to be polished can be effectively inhibited.

The nonionic surfactant may include a second nonionic surfactant having an HLB value of 8 or less.

The second nonionic surfactant has a relatively high lipophilicity and, in addition to the functions described above, can also function as anti-foaming agents within the polishing composition. This can help inhibit the formation of bubbles in the polishing composition.

The polishing composition for a semiconductor process may include 20 parts by weight or more of the second nonionic surfactant based on 100 parts by weight of the total nonionic surfactant. The polishing composition for a semiconductor process may include 25 parts by weight or more of the second nonionic surfactant based on 100 parts by weight of the total nonionic surfactant. The polishing composition for a semiconductor process may include 30 parts by weight or more of the second nonionic surfactant based on 100 parts by weight of the total nonionic surfactant. The polishing composition for a semiconductor process may include 35 parts by weight or more of the second nonionic surfactant based on 100 parts by weight of the total nonionic surfactant. The polishing composition for a semiconductor process may include 75 parts by weight or less of the second nonionic surfactant based on 100 parts by weight of the total nonionic surfactant. The polishing composition for a semiconductor process may include no more than 70 parts by weight of the second nonionic surfactant based on 100 parts by weight of the total nonionic surfactant. The polishing composition for a semiconductor process may include 65 parts by weight or less of the second nonionic surfactant based on 100 parts by weight of the total nonionic surfactant. The polishing composition for a semiconductor process may include 60 parts by weight or less of the second nonionic surfactant based on 100 parts by weight of the total nonionic surfactant.

In such cases, the polishing composition can contribute to effectively suppressing bubbles that are generated while being sprayed or polished through the pipe.

The nonionic surfactant may include a first nonionic surfactant and a second nonionic surfactant together. This allows the polishing composition to simultaneously impart the effects attributable to each of the surfactants described above.

The content of the first and second nonionic surfactants can be measured by High Performance Liquid Chromatography Mass Spectrometer (HPLC-MS).

The nonionic surfactant may further include a nonionic surfactant other than the first nonionic surfactant and the second nonionic surfactant. For example, the nonionic surfactant may further include a nonionic surfactant having an HLB value greater than 8 and less than 10.

The surfactant may include a polymeric surfactant. The polymeric surfactant may have a weight average molecular weight of 150 g/mol to 3,000 g/mol.

In the present disclosure, a polymeric surfactant having a controlled chain length may be applied to the polishing composition. This can effectively prevent the polishing rate of the polishing composition on the polishing target surface from being reduced by surfactants adsorbed onto the polishing target surface. It can also help control the viscosity of the polishing composition within a stable range.

The weight average molecular weight of polymeric surfactants is measured by gel permeation chromatography (GPC).

The polymeric surfactant may have a weight average molecular weight of 150 g/mol to 3,000 g/mol. The weight average molecular weight may be greater than or equal to 300 g/mol. The weight average molecular weight may be 500 g/mol or more. The weight average molecular weight may be 2500 g/mol or less. The weight average molecular weight may be 2000 g/mol or less. The weight average molecular weight may be 1500 g/mol or less. In this case, the polishing rate of the polishing composition to the silicon oxide film can be stably controlled while effectively improving the affinity of the polishing composition for the silicon oxide film. Furthermore, when the weight average molecular weight is adjusted as described above, it is possible to effectively suppress excessive generation of bubbles that may occur as the viscosity of the polishing composition increases.

The surfactant can be a fluorinated surfactant. The surfactant may be a fluoroalkyl alkylene oxide-based compound. The surfactant may be a compound according to Formula 1 below.

$$[\text{Formula 1}] \qquad R_f\text{-}(R_n\text{-}0)_x\text{-}H$$

In Formula 1, wherein $R_f$ is a fluoroalkyl group having a carbon number from 3 to 10, $R_n$ is an alkylene group having a carbon number from 2 to 3, and x is an integer from 2 to 15.

In Formula 1 above, $R_f$ may be a perfluoroalkyl group having a carbon number of 3 to 10.

Surfactants include, for example, triethylene glycol perfluoropentyl ether, triethylene glycol perfluorohexyl ether, triethylene glycol perfluoroheptyl ether, tetraethylene glycol perfluoropentyl ether, tetraethylene glycol perfluorohexyl ether, tetraethylene glycol perfluoroheptyl ether, pentaethylene glycol perfluoropentyl ether, pentaethylene glycol perfluorohexyl ether, pentaethylene glycol perfluoroheptyl ether, hexaethylene glycol perfluoropentyl ether, hexaethylene glycol perfluorohexyl ether, hexaethylene glycol perfluoroheptyl ether, and the like.

The surfactant with the structure of Formula 1 may be classified as either first nonionic surfactants or second nonionic surfactants based on HLB value of the surfactant. The surfactant having the structure of Formula 1 may also not be classified as either a first nonionic surfactant or a second nonionic surfactant based on HLB value of the surfactant. For example, $F\text{-}(CF_2)_6\text{-}(CH_2CH_2O)_3H$ has an HLB value of about 5.88, which corresponds to a second nonionic surfactant, and $F\text{-}(CF_2)_6\text{-}(CH_2CH_2O)_8H$ has an HLB value of about 10.51, which corresponds to a first nonionic surfactant.

The polishing composition for a semiconductor process may contain 10 ppm or more of the surfactant. The polishing composition for a semiconductor process may include 20 ppm or more of the surfactant. The polishing composition for a semiconductor process may include 50 ppm or more of the surfactant. The polishing composition for a semiconductor process may include 100 ppm or more of the surfactant. The polishing composition for a semiconductor process may include 150 ppm or more of the surfactant. The polishing composition for a semiconductor process may include 500 ppm or less of the surfactant. The polishing composition for a semiconductor process may include 450 ppm or less of the surfactant. In such a case, the affinity of the polishing composition to the surface to be polished can be effectively improved while suppressing excessive foaming during the polishing process.

Antifoaming agent

The polishing composition for a semiconductor process may further include an antifoaming agent. The antifoaming agent is a substance distinct from the surfactant above.

Antifoaming agents are substances that inhibit the formation of bubbles in the polishing composition when an external force is applied to the polishing composition.

The antifoaming agent may include a water-soluble polymer. The water-soluble polymer can be evenly distributed in the polishing composition without excessively increasing the viscosity of the composition, thereby effectively inhibiting the formation of bubbles in the polishing composition.

The water-soluble polymer may include a polyglycerin-based compound.

A polyglycerin-based compound refers to polyglycerin and derivatives thereof. For example, polyglycerin-based compounds may be polyglycerin-3, polyglycerin-4, polyglycerin-5, polyglycerin-10, polyglycerin-20, and the like.

The water-soluble polymer may have a weight average molecular weight of 200 g/mol to 2,000 g/mol. The weight average molecular weight may be greater than or equal to 500 g/mol. The weight average molecular weight may be less than or equal to 1,500 g/mol. The weight average molecular weight may be 1,200 g/mol or less. In this case, the bubble formation that may occur during the polishing process can be effectively suppressed, and the abrasive particle can be stably dispersed.

The weight average molecular weight of water-soluble polymers is measured by Gel Permeation Chromatography (GPC).

The polishing composition for a semiconductor process may include the antifoaming agent of 0.001 wt%. The polishing composition for a semiconductor process may include the antifoaming agent of 0.003 wt% or more. The polishing composition for a semiconductor process may include antifoaming agent of 0.005 wt% or more. The polishing composition for a semiconductor process may include antifoaming agent of 0.1 wt% or less. The polishing composition for a semiconductor process may include antifoaming agent of 0.08 wt% or less. The polishing composition for a semiconductor process may include antifoaming agent of 0.05 wt% or less. The polishing composition for a semiconductor process may include antifoaming agent of 0.03 wt% or less of antifoaming agent. In this case, the generation of bubbles in the polishing composition during the polishing process can be suppressed, which can effectively improve the convenience of the polishing process.

Other Additives

The polishing composition for a semiconductor process may further include other additives. The additive is not limited as long as it is normally applied in the CMP field. For example, the additives may be at least one of chelating agent, oxidizing agent, acid, pH adjuster, dispersant, polishing rate enhancer, polishing regulator, polishing pad protectant, or preservative.

The polishing composition for a semiconductor process may further include a chelating agent. Metals or metal ions removed from a substrate surface by the polishing process may reattach or remain on the polished substrate surface and may form defects. In particular, metals such as tungsten may be readily soluble in polishing compositions under certain conditions but may have properties that make them susceptible to adhering to the surface to be polished. Chelating agents may adsorb to these metals or metal ions, facilitating the removal of the metals and the like. This may further increase the polishing rate of the polishing composition and effectively inhibit the formation of defects on a polished substrate surface due to particle reattachment.

For example, chelating agent may be at least one of butyric acid, citric acid, tartaric acid, succinic acid, oxalic acid, acetic acid, adipic acid, capric acid, caproic acid, caprylic acid, carboxylic acid, glutaric acid, glutamic acid, glycolic acid, thioglycolic acid, formic acid, mandelic acid, fumaric acid, lactic acid, lauric acid, malic acid, maleic acid, , malonic acid, myristic acid, plamitic acid, phthalic acid, isophthalic acid, terephthalic acid, citraconic acid, propionic acid, pyruvic acid, stearic acid, valeric acid, benzoic acid, phenylacetic acid, naphthoic acid, aspartic acid, amino acids, or ethylenediaminetetraacetic acid.

The amino acids may be glycine, $\alpha$-alanine, $\beta$-alanine, L-asparaginic acid, N-methylglycine (methylglycine), or combinations thereof.

A chelating agent may contain two or more carboxylic or alcoholic groups in its molecule. Two or more types of chelating agents comprising two or more carboxyl groups or alcohol groups in a molecule can be applied as chelating agents. Specifically, the chelating agent may include any one selected from the group consisting of ethylenediaminetetraacetic acid (EDTA), glycine, carboxylic acid, and a combination thereof. A carboxylic acid group is a compound comprising at least one carboxyl group in its molecule.

The polishing composition for a semiconductor process may include 0.003 wt% to 0.5 wt% of a chelating agent. The polishing composition for a semiconductor process may include 0.005 wt% or more of the chelating agent. The polishing composition for a semiconductor process may include 0.3 wt% or less of the chelating agent. In this case, the polishing rate of the polishing composition can be controlled to a suitable level, and the frequency of defects on the polished substrate can be reduced.

The polishing composition for a semiconductor process may further include an oxidizing agent. The oxidizing agent oxidizes metals such as tungsten, making it easier to planarize the surface to be polished and increasing the polishing and etching speed of the polishing composition.

Oxidizing agents may be one selected from the group consisting of hydrogen peroxide, urea peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodic acid, ammonium persulfate, benzoyl peroxide, calcium peroxide, barium peroxide, sodium peroxide, urea hydrogen peroxide, and combinations thereof.

The polishing composition for a semiconductor process may include from 0.01 wt% to 5 wt% of an oxidizing agent. In such cases, the composition may exhibit good abrasive properties on the metal and may inhibit the formation of an oxide film on the metal to be polished during the polishing process.

The polishing composition for a semiconductor process may further include a copper corrosion inhibitor. The copper corrosion inhibitor may include an azole-based compound.

Azole-based compound includes, for example, Benzotriazole (BTA), 5-Methyl-1H-Benzotriazoletriazole (5-MBTA), 3-Amino-1,2,4-Triazole, 5-Phenyl-1H-Tetrazole, 3-Amino-5-Methyl-4H-1,2,4-Triazole, 5-Aminotetrazole (ATZ), 1,2,4-Triazole, Tolytriazole, and combinations thereof.

The azole-based compound may include one selected from the group consisting of 5-Aminotetrazole (ATZ), 5-Methyl-1H-Benzotriazole (5-MBTA), and combinations thereof.

Azole-based compounds can act on the copper surface during the polishing process to prevent copper corrosion.

The azole-based compound may include from 0.02 to 2.00 parts by weight, 0.03 to 1.5 parts by weight, 0.5 to 1.5 parts by weight, based on 100 parts by weight of the abrasive particle.

When the azole-based compound is included in this range, the corrosion protection effect of the copper surface of the polishing composition for semiconductor processing can be obtained and in particular, a strong corrosion protection effect can be provided on relatively large surfaces such as via hole surfaces.

The polishing composition for a semiconductor process may further include an acid. The acid component may be, for example, hydrochloric acid, phosphoric acid, sulfuric acid, hydrofluoric acid, bromic acid, iodic acid, formic acid, malonic acid, maleic acid, oxalic acid, acetic acid, citric acid, propionic acid, fumaric acid, lactic acid, salicylic acid, pimelin, benzoic acid, succinic acid, phthalic acid, butyric acid, glutaric acid, glutamic acid, glutamine acid, glycolic acid, lactic acid, asparagine acid, tartaric acid, and salts thereof.

The polishing composition for a semiconductor process may further include a pH adjuster in addition to the acid. The pH adjuster may be, for example, any one selected from the group consisting of ammonia, aminomethylpropanol, tetramethylammonium hydroxide, potassium hydroxide, sodium hydroxide, magnesium hydroxide, rubidium hydroxide, cesium hydroxide, sodium bicarbonate, sodium carbonate, imidazole, and combinations thereof.

The polishing composition for a semiconductor process may further include a dispersant.

The dispersant can prevent agglomeration and uniformly disperse the abrasive particles within the polishing composition. Cationic dispersants can positively increase the zeta potential of the polishing composition, while anionic dispersants can negatively decrease the zeta potential of the polishing composition.

Dispersants can include anionic small molecules, cationic polymers, organic acids, and the like.

The anionic small molecule of the dispersant may be one or more selected from oxalic acid, citric acid, polysulfonic acid, polyacrylic acid, polymethacrylic acid, and combinations thereof.

The cationic polymer of the dispersant may be one or more selected from polylysine, polyethyleneimine, benzethonium chloride, bronidox, cetrimonium bromide, cetrimonium chloride, dimethyldioctadecylammonium chloride, tetramethylammonium hydroxide, distearyldimethylammonium chloride, polyarylamine, and combinations thereof.

The organic acid in the dispersant may be one or more selected from hydroxylbenzoic acid, ascorbic acid, picolinic acid, glutamic acid, tryptophan, aminobutyric acid, and combinations thereof.

The polishing rate enhancer is an additive for increasing the polishing rate for the substrate to be polished or wiring to be polished, and may be one or more selected from potassium nitrate, iron nitrate, ammonium hydroxide, citric acid, acetic acid, and combinations thereof.

The polishing regulator is to minimize adsorption of the polishing composition to the metal surface and may include ammonium compounds, potassium nitrate, amino acids, salts thereof, and the like.

The polishing composition for a semiconductor process may include a solvent. The solvent may be water, and more particularly may be ultrapure water.

## Abrasive Properties of Polishing Compositions

The polishing rate for the silicon oxide film of the polishing composition for a semiconductor process may be 1000 Å/min or more. The polishing rate may be 1100 Å/min or more. The polishing rate may be 1200 Å/min or more. The polishing rate may be 3000 Å/min or less. The polishing rate may be 2500 Å/min or less. The polishing rate may be 2000 Å/min or less.

The polishing rate for the tungsten film of the polishing composition for a semiconductor process may be 50 Å/min or more. The polishing rate may be 70 Å/min or more. The polishing rate may be 500 Å/min or less. The polishing rate may be 300 Å/min or less. The polishing rate may be 200 Å/min or less.

In such cases, the polishing composition may exhibit a good silicon oxide polishing rate selectivity ratio relative to tungsten polishing rate.

The Ra value of the tungsten film measured after polishing with a polishing composition for 30 seconds may be 3 nm or less. The Ra value may be 2 nm or less. In such cases, the polishing composition may provide a smooth polished surface.

Ra values are measured according to ISO 4287.

Polishing of each thin film is performed at a pressure of 2.2 psi, carrier speed of 87 rpm, plate speed of 93 rpm, and slurry flow rate of 250 mL/min. The polishing pad is a model SR-300 from SK enpulse Co., Ltd..

To measure the polishing rate of each thin film, a polishing machine may be used, for example, the AP-300 model from CTS.

## Method of Manufacturing a Substrate

A method of manufacturing a substrate of the present disclosure includes polishing the substrate by applying the polishing composition for a semiconductor process as a slurry.

The substrate may include at least one of an insulating film, metallic wiring, or a barrier layer on the top surface. The metallic wiring may include copper or tungsten. If the metallic wiring includes copper, the barrier layer may include at least tantalum or tantalum nitride. If the metallic wiring includes tungsten, the barrier layer may include titanium and/or titanium nitride.

Specifically, the process of polishing a substrate may be performed by contacting the substrate to be polished with a polishing composition for a semiconductor process supplied from a spray nozzle to a polishing pad, while the polishing head holding the substrate is rotated and the table to which the polishing pad is attached is also rotated.

The process of polishing the substrate may further include, if desired, conditioning the surface of the polishing pad prior to polishing.

Polishing composition for a semiconductor process can polish wafers that come into contact with the polishing pad as they penetrate toward the surface of the substrate.

In the process of polishing the substrate, a pressure of 6.89 kPa to 48.26 kPa may be applied. The pressure may be from 13.79 kPa to 34.47 kPa.

The process of polishing the substrate may last from 50 seconds to 10 minutes. However, this can vary depending on targeting degree of polishing.

The description of polishing compositions for semiconductor processes is redundant to the foregoing and is therefore omitted.

The method of manufacturing the substrate may further include a cleaning process to clean the polished substrate.

The cleaning process may be carried out by cleaning the polished substrate through purified water and inert gas.

Specific embodiments are described in more detail below. The following embodiments are illustrative only to aid in understanding the present disclosure and are not intended to limit the scope of the present invention.

## Manufacturing Example: Preparation of a Polishing Composition

Example 1: A total of 100 wt% of a polishing composition was prepared by mixing 3 wt% of silica having an average diameter (based on the primary particle) of 42 nm, which is surface-modified with (3-aminopropyl) triethoxysilane as an abrasive particle, and 100 ppm (by weight) of surfactant in ultrapure water as a solvent. The pH of the polishing composition was adjusted to 4.0.

The surfactant was a fluorinated surfactant. The surfactants included $F(CF_2)_6\text{-}(CH_2\text{-}CH_2O)_2H$ and $F(CF_2)_6\text{-}(CH_2\text{-}CH_2O)_3H$ of 28.2 wt%, $F(CF_2)_6\text{-}(CH_2\text{-}CH_2O)_4H$ 20.5 wt%, $F(CF_2)_6\text{-}(CH_2\text{-}CH_2O)_5H$ of 19.1 wt%, $F(CF_2)_6\text{-}(CH_2\text{-}CH_2O)_6H$ of 14.65 wt%, $F(CF_2)_6\text{-}(CH_2\text{-}CH_2O)_7H$ of 9.35 wt%, $F(CF_2)_6\text{-}(CH_2\text{-}CH_2O)_8H$ of 4.95 wt%, $F(CF_2)_6\text{-}(CH_2\text{-}CH_2O)_9H$ of 2.2 wt%, $F(CF_2)_6\text{-}(CH_2\text{-}CH_2O)_{10}H$ of 0.85 wt%, $F(CF_2)_6\text{-}(CH_2\text{-}CH_2O)_{11}H$ of 0.2 wt%.

Example 2: A total of 100 wt% of a polishing composition was prepared under the same conditions as in Example 1, except that it further contained 0.01 wt% polyglycerin having a weight average molecular weight of 750 g/mol (excluding ultrapure water by that amount).

Example 3: A total of 100 wt% polishing composition was prepared under the same conditions as in Example 1, except that surfactant was applied at 30 ppm.

Comparative Example 1: A total of 100 wt% polishing composition was prepared under the same conditions as Example 1 except that no nonionic surfactant was applied.

Comparative Example 2 A total of 100 wt% polishing composition was prepared under the same conditions as Example 1, except that 1000 ppm of a nonionic surfactant was applied.

Comparative Example 3: A total of 100 wt% polishing composition was prepared by adding and mixing 2 wt% of unmodified silica with an average diameter of 45 nm (based on the primary particle), a nitric acid as a pH adjuster, and ultrapure water as a solvent. The pH of the polishing composition was adjusted to 3.8.

The content of each component in the polishing composition of each example and comparative example, the zeta potential of the polishing composition, and the viscosity of the polishing composition were as set forth in Table 1 below.

## Evaluation Example: Measuring Bubble Generation

3 L of the polishing composition for each example and comparative example was added to a 5 L volume glass reactor. The polishing composition was stirred at a speed of 1,000 rpm for 30 minutes at 25°C with a 4-blades rotor with a total length of 10 cm. After ten minutes from the end of stirring, the height of the bubbles formed in the glass reactor was measured. The volume of the bubbles was calculated from the height value and the inside diameter of the glass reactor containing the polishing composition.

The calculated bubble volume values for examples and comparative examples are shown in Table 3 below.

## Evaluation Example: Dynamic Surface Tension Measurement of Abrasive Compositions

The dynamic surface tension of the polishing compositions of Example 3 and Comparative Example 1 was measured by the maximum bubble pressure method using the bubble pressure tensiometer, BPA-1P manufactured from Sinterface Tech. For the dynamic surface tension measuring, a time interval of 1 second and a sample volume of 2 mL were applied. The measured dynamic surface tension was calculated as the value at a bubble lifetime of 10 seconds.

The measurements for each Example and Comparative Example are listed in Table 3 below.

**Evaluation Example: Measuring the Polishing Rate for Each Thin Film**

The polishing compositions of each of Examples 1 to 3 and Comparative Examples 1 and 2 were applied as a slurry to measure the polishing rate for each of the silicon oxide film and tungsten film formed on a 300 mm diameter wafer. The polishing rate for each thin film was measured at a polishing time of 60 seconds, pressure of 2.2 psi, carrier speed of 93 rpm, platen speed of 87 rpm, and slurry flow rate of 300 mL/min, and the polishing machine was the AP-300 model of CTS corporation.

The polishing rate measurements for each thin film in the Example and Comparative Example are shown in Table 3 below.

**Evaluation Example: Measuring Defect Density on a Polished Surface**

The polishing compositions of Examples 1 to 3, Comparative Examples 1 and 2 were applied as a slurry to polish a silicon oxide film formed on a wafer having a diameter of 300 mm. The silicon oxide film was polished under the same conditions as those applied in the previous polishing rate measurement evaluation example.

The number of defects formed on the surface of the polished SiOz wafer was measured with a wafer defect detector, the AIT-XP+ model manufactured from KLA Tencor.

The measurement results for each Example and Comparison Example are shown in Table 3 below.

[Table 1]

| | Abrasive particle Content (wt%) | Surface Modifiers Content (ppm) | Surfactants Content (ppm) | Polyglycerin Content (wt%) | Zeta Potential (mV) | Viscosity (cP) |
|---|---|---|---|---|---|---|
| Example 1 | 3 | 150 | 100 | 0 | 28 | 1.02 |
| Example 2 | 3 | 150 | 100 | 0.01 | 28 | 1.02 |
| Example 3 | 3 | 150 | 30 | 0 | 28 | 1.02 |
| Comparative Example 1 | 3 | 150 | 0 | 0 | 28 | 1.02 |
| Comparative Example 2 | 3 | 150 | 1000 | 0 | 28 | 1.02 |
| Comparative Example 3 | 2 | 0 | 0 | 0 | -23 | 1.02 |

[Table 2]

| | The Amount of Bubble (mL) | Dynamic Surface Tension (mN/m) |
|---|---|---|
| Example 1 | 30 | - |
| Example 2 | 20 | - |
| Example 3 | 20 | 66 |
| Comparative Example 1 | 25 | 71 |
| Comparative Example 2 | 500 | - |
| Comparative Example 3 | 50 | - |

[Table 3]

| | Polishing Rate for Silicon Oxide Films (Å/min) | Polishing Rate for Tungsten Film (Å/min) | Polished Surface Defect Density (number/wafer) |
|---|---|---|---|
| Example 1 | 1280 | 100 | 85 |
| Example 2 | 1280 | 100 | 34 |

(continued)

|  | Polishing Rate for Silicon Oxide Films (Å/min) | Polishing Rate for Tungsten Film (Å/min) | Polished Surface Defect Density (number/wafer) |
|---|---|---|---|
| Example 3 | 1280 | 110 | 30 |
| Comparative Example 1 | 1280 | 100 | 890 |
| Comparative Example 2 | 1180 | 160 | 50 |
| Comparative Example 3 | - | - | - |

In terms of bubble generation, Examples 1 to 3 represented 30 mL or less, while Comparative Example 2 represented 500 mL. In particular, Example 2 with polyglycerin showed lower bubble generation than Example 1 which is without polyglycerin.

In terms of the defect density on the polished surface, 100 or less defects per wafer were measured in the Examples and Comparative Example 2, while more than 850 defects per wafer was measured in Comparative Example 1. It is believed to be due to the fact that the polishing composition with a controlled contact angle to the silicon oxide film can be evenly distributed within the polishing target surface during the polishing process, and the surfactant effectively hinders the adsorption of abrasives and organic particles on the polishing target surface.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the disclosure is also inclusive of the claims and their equivalents, i.e., all variations within the scope of the claims and their equivalents are to be construed as being included in the disclosure.

**Claims**

1. A polishing composition for a semiconductor process, the polishing composition comprising:

   abrasive particles; and
   a surfactant;
   wherein a volume of foam measured immediately after stirring 3L of the polishing composition at 25°C at a speed of 1,000 rpm for 30 minutes and standing for 10 minutes is 50 mL or less.

2. The polishing composition of claim 1, wherein a viscosity of the polishing composition ranges from 0.7 cP to 1.5 cP at 25°C.

3. The polishing composition of claim 1, wherein a dynamic surface tension at a bubble lifetime of 10 seconds ranges from 25 mN/m to 70 mN/m.

4. The polishing composition of claim 1, wherein the surfactant comprises a nonionic surfactant, and wherein the nonionic surfactant comprises a first nonionic surfactant having a Hydrophilic-Lipophilic Balance (HLB) value of 10 or more.

5. The polishing composition of claim 1, wherein the surfactant comprises a nonionic surfactant, and wherein the nonionic surfactant comprises a second nonionic surfactant having a Hydrophilic-Lipophilic Balance (HLB) value of 8 or less.

6. The polishing composition of claim 1, wherein the surfactant comprises a polymeric surfactant, and wherein the polymeric surfactant has a weight average molecular weight of 150 g/mol to 3,000 g/mol.

7. The polishing composition of claim 1, further comprising an antifoaming agent, wherein the antifoaming agent comprises a water-soluble polymer.

8. The polishing composition of claim 7, wherein a weight average molecular weight of the antifoaming agent ranges from 200 g/mol to 2,000 g/mol.

9. The polishing composition for of claim 7, wherein the antifoaming agent comprises a polyglycerin-based compound.

10. The polishing composition of claim 1, wherein a pH of the polishing composition ranges from 2 to 5.

11. The polishing composition of claim 1, wherein a surface of the abrasive particles has a positive charge.

12. A method of manufacturing a substrate, the method comprising:

polishing a substrate by applying a polishing composition for a semiconductor process as a slurry,
wherein the polishing composition comprises abrasive particles and a surfactant, and
wherein a volume of foam measured immediately after stirring 3L of the polishing composition at 25°C at a speed of 1,000 rpm for 30 minutes and standing for 10 minutes is 50 mL or less.

| | Europäisches Patentamt<br>European Patent Office<br>Office européen des brevets | **EUROPEAN SEARCH REPORT** | **Application Number**<br>EP 24 20 2946 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | WO 2025/009951 A1 (SK ENPULSE CO LTD [KR]) 9 January 2025 (2025-01-09) * examples 1-3 * | 1-12 | INV.<br>C09G1/02<br>C09K3/14 |
| X | CN 116 144 270 A (HUNAN SANAN SEMICONDUCTOR CO LTD) 23 May 2023 (2023-05-23) * paragraphs [0015], [0016], [0035], [0038], [0039]; claims 1-11; examples 1-12 * | 1-12 | |
| X | CN 105 950 115 A (YANCHENG INST TECHNOLOGY) 21 September 2016 (2016-09-21) * claims 1-10; example 7 * | 1-12 | |

| | TECHNICAL FIELDS SEARCHED (IPC) |
|---|---|
| | C09G<br>C09K |

The present search report has been drawn up for all claims

| Place of search | Date of completion of the search | Examiner |
|---|---|---|
| Munich | 17 February 2025 | Schmitt, Johannes |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 2946

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2025

| Patent document cited in search report | Publication date | Patent family member(s) | Publication date |
|---|---|---|---|
| WO 2025009951 A1 | 09-01-2025 | KR 20250007832 A<br>WO 2025009951 A1 | 14-01-2025<br>09-01-2025 |
| CN 116144270 A | 23-05-2023 | NONE | |
| CN 105950115 A | 21-09-2016 | NONE | |

EPO FORM P0459

For more details about this annex : see Official Journal of the European Patent Office, No. 12/82

**EP 4 534 622 A1**

**Patent documents cited in the description**

- KR 1020230131542